# EUROPEAN PATENT SPECIFICATION

(11) **EP 0 780 897 B1**
(45) Date of publication and mention of the grant of the patent: **07.03.2001**
(21) Application number: 95830535.1
(22) Date of filing: 22.12.1995
(51) Int. Cl.: H01L 23/482, H01L 29/417, H01L 29/423, H01L 29/78, H01L 29/739, H01L 29/06, H01L 29/10

(54) **High-speed MOS-technology power device integrated structure with reduced gate resistance**
Hochgeschwindigkeit-MOS-Technologie-Leistungsanordnung in integrierter Struktur mit reduziertem Gatewiderstand
Structure intégrée d'un dispositif de puissance en technologie-MOS à grande vitesse avec une résistance de grille réduite

(43) Date of publication of application: 25.06.1997
(73) Proprietor: Consorzio per la Ricerca sulla Microelettronica nel Mezzogiorno, 95121 Catania (IT)
(72) Inventor: Grimaldi, Antonio, I-95030 Mascalucia (Catania) (IT); Schillaci, Antonio, I-98100 Messina (IT)
(74) Representative: Mittler, Enrico

(56) References cited:
- EP-A- 0 671 769
- US-A- 5 208 471
- MENA J ET AL: "High frequency performance of VDMOS power transistors" , INTERNATIONAL ELECTRON DEVICES MEETING. TECHNICAL DIGEST, WASHINGTON, DC, USA, 8-10 DEC. 1980 , 1980, NEW YORK, NY, USA, IEEE, USA, PAGE(S) 91 - 94 XP002003699 * page 92, paragraph 1 *
- PATENT ABSTRACTS OF JAPAN vol. 014, no. 387 (E-0967), 21 August 1990 & JP-A-02 143566 (TOSHIBA CORP), 1 June 1990,
- PATENT ABSTRACTS OF JAPAN vol. 005, no. 040 (E-049), 17 March 1981 & JP-A-55 163877 (TOSHIBA CORP), 20 December 1980,

## Description

The present invention relates to a high-speed MOS-technology power device integrated structure with reduced gate resistance, more particularly to a Vertical Double-Diffused power MOS (VDMOS) or an Insulated Gate Bipolar Transistor (IGBT).

MOS-technology power devices are particularly suitable for applications wherein high currents at high voltages must be switched in times of the order of some hundreds of nanoseconds. It is therefore necessary to have MOS-technology power devices capable of handling high powers in extremely short times.

Conventional MOS-technology power devices have a cellular structure, comprising several millions elementary cells integrated in a semiconductor substrate to form a bidimensional array; each elementary cell represents an elementary VDMOS and is connected in parallel to all the other cells, in order to contribute for a given fraction to the overall current of the power device.

Each cell comprises a polygonal P type body region (square or hexagonal) formed in a lightly doped N type layer; a polygonal source region is provided inside each body region; the polygonal source region defines a polygonal annular portion comprised between the external edge of the source region and the edge of the body region; such polygonal annular portion, covered by a thin oxide layer (gate oxide) and a polysilicon layer (polysilicon gate), forms a channel region of the elementary VDMOS.

The polysilicon gate and the underlying gate oxide form a mesh over the surface of the lightly doped N type layer, since they are substantially are continuous layers with openings over the center of the elementary cells. Elongated regions with no elementary cells are provided in the gate oxide and polysilicon layers; at this elongated regions the polysilicon layer is contacted by gate metal fingers extending from a gate metal pad. The remaining surface of the chip is covered by a source metal layer contacting the source regions of all the elementary cells.

The cellular structure allows to achieve high channel lengths per unit area; this in turn limits the voltage drop across the power device when it is in the "on" state (i.e. the so-called "on-state resistance" R_{DSon}): this is an important parameter, because it is directly related to the steady-state power dissipation of the power device.

However, due to the fact that the resistivity of polysilicon is not negligible, a parasitic resistance is intrinsecally introduced by the polysilicon layer in series between the gate metal pad and the gate of the cells; the farther a cell from a gate metal finger, the higher its gate resistance. Such a resistance, together with the input capacitances of the cells and with other parasitic capacitances (e.g. the parasitic capacitances between the polysilicon gate and the substrate in the area between the cells), forms an RC circuit which strongly affects the dynamic performances of the power device.

Although the polysilicon gate layer is normally doped to reduce its resistivity, the effects on the dynamic performances of the power device are limited.

Furthermore, since in order to maximize the chip area which contributes to the current conduction in the on state (active area) it is now common to provide a bonding pad for the source lead directly over the active area of the chip (a technique known as "bonding on active area"), the region of the chip where said bonding pad is formed cannot be traversed by gate metal fingers, because otherwise a short-circuit would be caused between source and gate due to the bonding of the source Lead. The area of the bonding pad is such that the regular distance between adjacent gate metal fingers cannot be respected. As a consequence, the portion of active area under the source bonding pad is the last to be affected by the gate signal, and the elementary VDMOS' in said portion of the active area are therefore the Last to be turned on/off when the power device is driven on/off.

An example of an insulated gate field effect transistor applicable as a high proof voltage and high current power switching element is disclosed in the patent application EP 671 769.

In view of the state of the art described, it is an object of the present invention to provide a new MOS-technology power device integrated structure which overcomes the above-mentioned problems.

According to the present invention, such object is attained by means of a MOS-technology power device integrated structure comprising a plurality of substantially parallel first elongated doped semiconductor stripes of a second conductivity type formed in a semiconductor layer of a second conductivity type, each of said elongated stripes including a source region of the first conductivity type, an annular doped semiconductor region of the first conductivity type formed in the semiconductor layer and surrounding and merged with said elongated stripes, a plurality of first conductive insulated gate stripes each one extending over the semiconductor layer between two respective adjacent elongated stripes, said first conductive insulated gate stripes extending from a conductive insulated gate ring surrounding and merged with said plurality of first conductive insulated gate stripes, a plurality of conductive gate fingers each one extending over and electrically connected to a respective first conductive insulated gate stripe, and a plurality of source metal fingers, each one extending from a common source bonding pad over a respective elongated stripe and contacting said elongated stripe and the respective source region, so that the source metal fingers and the conductive gate fingers are interdigitated, at least one second conductive insulated gate stripe extending orthogonally to the first conductive insulated gate stripes between two opposite sides of said conductive insulated gate ring under said common source bonding pad, said second conductive insulated gate stripe being electrically insulated from said source bonding pad, and being merged with said first conductive insulated gate stripes at one end thereof and with said conductive insulated gate ring. An object of the present invention is also attained by a method according to claim 20.

A MOS-technology power device structure according to the present invention has no longer a cellular structure; the "body regions" are represented by the first elongated doped semiconductor stripes which are connected to the annular doped semiconductor region. Each first insulated gate stripe, which extends from an insulated gate ring between adjacent first insulated gate stripes,is contacted by a respective conductive gate finger, such as a metal finger or a metal silicide finger. In the region of the chip where the source bonding pad is to provided, at least one insulated gate stripe, also connected to the insulated gate ring, extends orthogonally to the first insulated gate stripes under the source bonding pad, and the first insulated gate stripes are connected at their ends to the second insulated gate stripe. Thus, even if the resistivity of the insulated gate layer (polysilicon) is relatively high, the parasitic gate resistance of the power device is quite small, because the gate signal can easily reach all the portions of active area of the device (also in the region of the active area covered by the source bonding pad, the gate signal is fed by means of the second insulated gate stripe). The dynamic performances of the power device are thus improved.

In a preferred embodiment, a second plurality of elongated doped semiconductor stripes of the first conductivity type is also provided, these further elongated stripes being also merged with said annular region; each elongated stripe of this second plurality is located under a respective first insulated gate stripe, so that the elongated stripes of the first plurality are intercalated with the elongated stripes of the second plurality.

The elongated stripes of the second plurality, being merged with the annular region, are at the same electric potential as the elongated stripes of the first plurality, i.e. at the source potential. The presence of a doped semiconductor stripe of the first conductivity type under the insulated gate layer has two major advantages. Firstly, it allows an improvement in the dynamic performances of the power device: in fact, being the stripe at the source potential, the parasitic capacitance associated to the insulated gate layer is an input capacitance (i.e. a capacitance between gate and source), while if the stripe were absent the parasitic capacitance would be between gate and drain (the semiconductor substrate). Due to the Miller effect, a capacitance between gate and drain affects more negatively the dynamic performances than an input capacitance. Secondly, the presence of the doped semiconductor stripes under the insulated gate stripes allows to flatten the electric field lines in the regions between the elongated stripes when the device is strongly reverse-biased (high reverse voltage applied between source and drain). Crowding of the electric field lines is thus avoided, so that early breakdowns at the edges of the doped semiconductor stripes are prevented; this leads to an increase in the breakdown voltage of the power device.

These and other features of the present invention will be made more evident by the following detailed description of a particular embodiment, described as a non-limiting example with reference to the annexed drawings, wherein:
Fig. 1 is a schematic top-plan view of a MOS-technology power device chip according to the present invention;
Fig. 2 is an enlarged view of a corner region of the chip of Fig. 1;
Fig. 3 is an enlarged view of a source bonding pad region of the chip of Fig. 1;
Fig. 4 is a cross-sectional view taken along line IV-IV of Fig. 2;
Fig. 5 is a cross-sectional view taken along line V-V of Fig. 2;
Fig. 6 is a cross-sectional view taken along line VI-VI of Fig. 2;
Fig. 7 is a cross-sectional view taken along line VII-VII of Fig. 2;
Fig. 8 is a cross-sectional view taken along line VIII-VIII of Fig. 3;
Fig. 9 is a cross-sectional view taken along line IX-IX of Fig. 3;
Fig. 10 is a schematic top-plan view of the MOS-technology power device of the present invention at the level of the silicon surface;
Figs. 11 to 16 are cross-sectional views taken along line VII-VII of Figure 2 showing some steps of a process for manufacturing a MOS-technology power device according to the present invention.

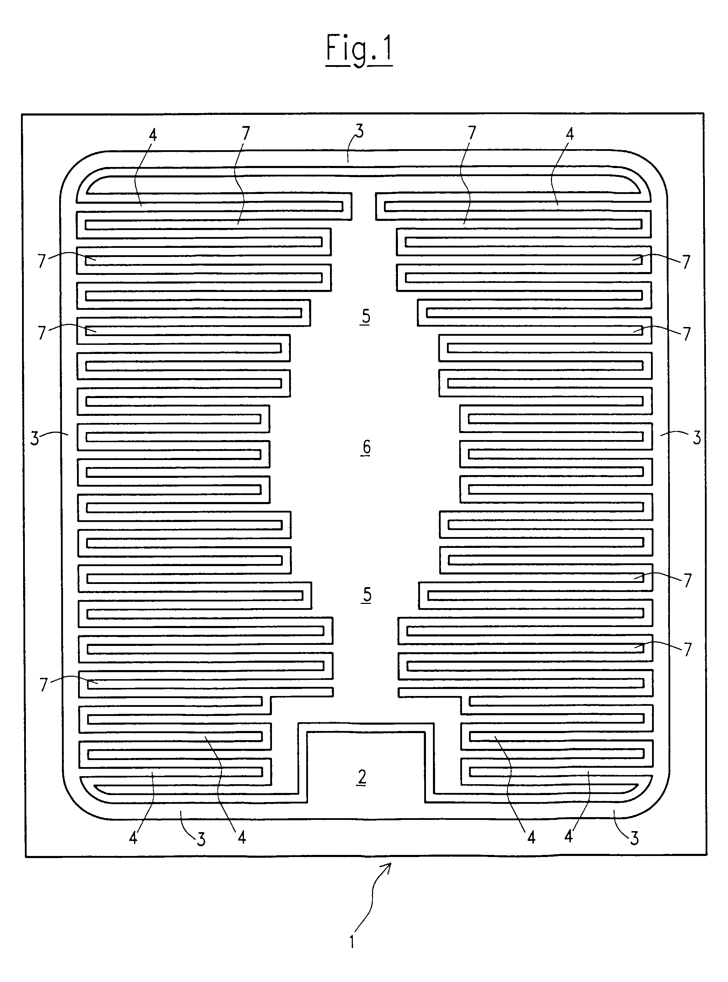

Figure 1 schematically shows in top-plan view a chip 1 of a MOS-technology power device according to the present invention. The chip 1 is provided, near its periphery, with a gate metal pad 2; a gate metal ring 3 running along the periphery of the chip 1 is connected at its edges to the gate pad 2. Metal gate fingers 4 depart horizontally from the gate metal ring 3 and extend towards the center of the chip 1.

At the center of the chip 1 a source metal plate 5 is provided; the source metal plate 5 has a central enlarged pad area 6; source metal fingers 7 depart horizontally from the source metal plate 5 and extend towards the periphery of the chip 1; the source metal fingers 7 are interdigitated with the gate metal fingers 4. The source metal plate 5 is rather narrow near the periphery of the chip 1 and becomes progressively wider approaching the pad area 6; this is because the source plate 5 must sustain a current which is smaller near the periphery of the chip 1 (where the current is the sum of a small number of contributions from the individual source fingers 7) and which becomes larger approaching the source pad area 6.

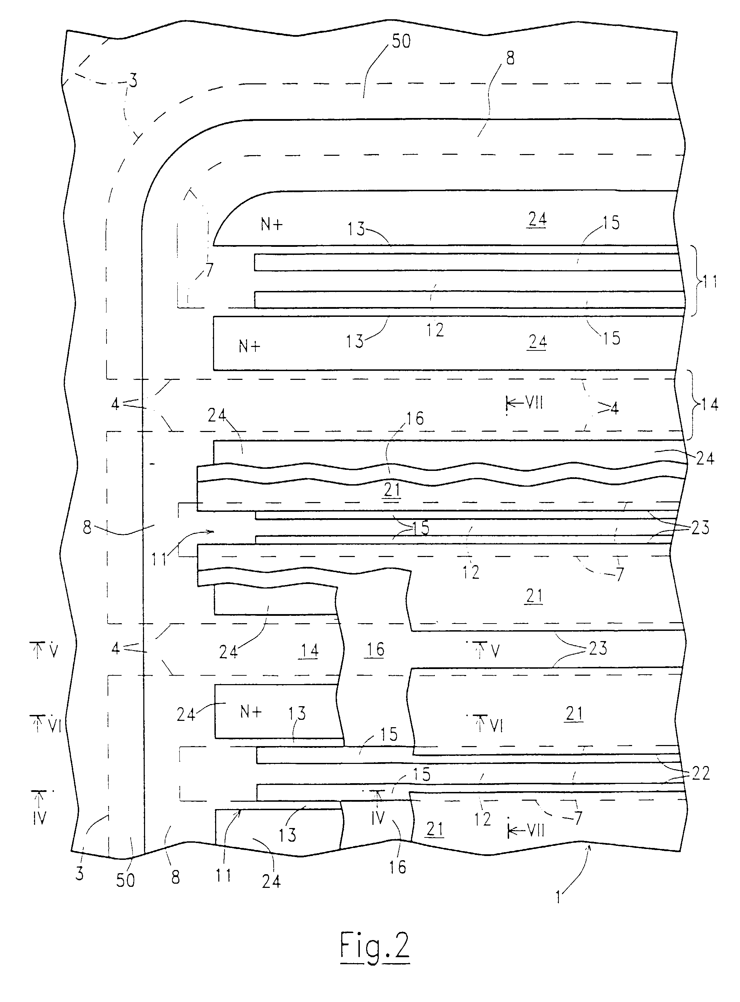

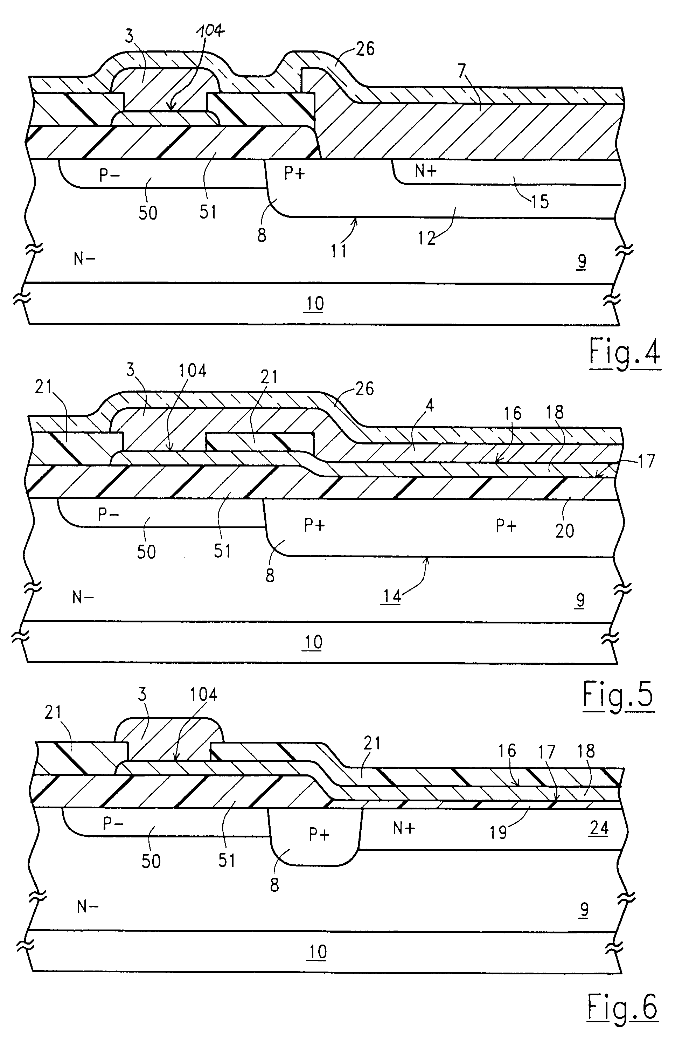

Figure 2 is an enlarged top-plan view of a corner region of the chip 1 of Figure 1, more precisely the upper-left corner; the gate metal ring 3, the gate fingers 4 and the source fingers 7 are shown in phantom for the sake of clarity. A P type ring 8 is visible, which in the shown embodiment is a P+ heavily doped ring, concentrical with the gate metal ring 3; as shown in the cross-sectional views of Figures 4, 5 and 6, the P type ring 8 is formed in a N- semiconductor layer 9 (typically a lightly doped epitaxial layer). The N- layer 9 is in turn superimposed on a heavily doped semiconductor substrate 10; the substrate 10 can be either of the N type, in the case of a power VDMOS, or of the P type, in the case of an Insulated Gate Bipolar Transistor (IGBT). All the conductivity types given above relates to N-channel devices; for P-channel devices all the conductivity types must be reversed.

A P- ring 50 is provided all around the P type ring 8 (Figs. 2 and 4-6); the P- ring 50 forms in a per-se known way an edge structure for the P type ring 8, and spreads the depletion region associated to the junction between the P type ring 8 and the N- layer 9, thus increasing the breakdown voltage of the power device.

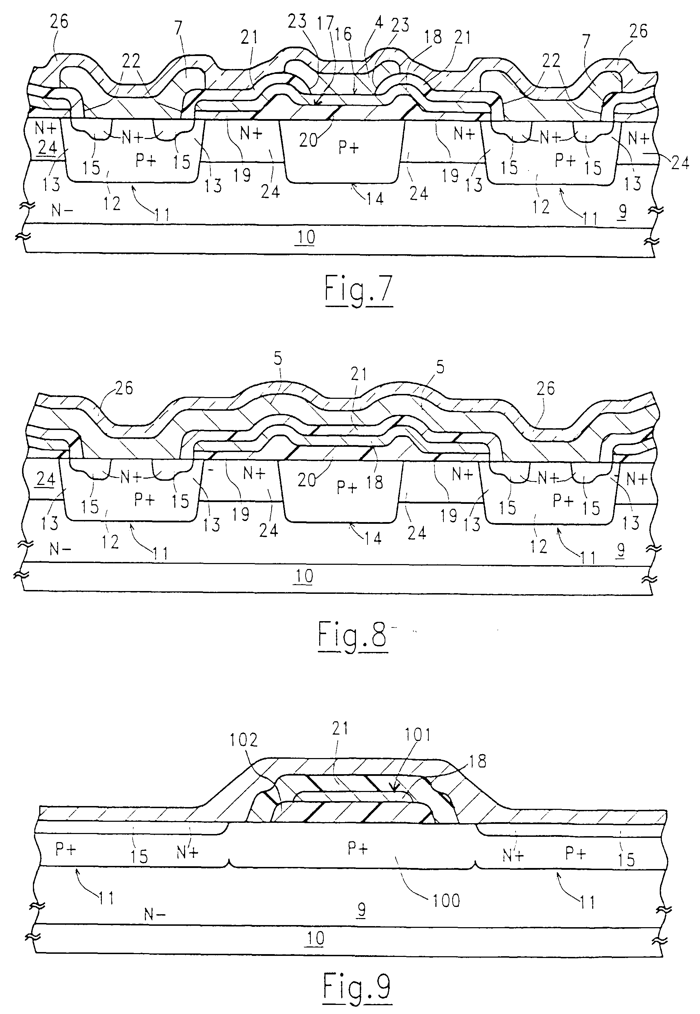

As visible in Figs. 2 and 4, a first plurality of P type stripes 11 departs horizontally from the P type ring 8. The stripes 11 forms so-called "body regions" of the power device; as better visible in Fig. 7 (which is a cross-section in a direction transversal to the stripes 11), each stripe 11 comprises a central P+ portion 12 (analogous to the so-called "deep body region" of the cellular devices of the known art) and two shallower and more lightly doped portions 13 at the sides of and merged with the P+ portion 12, forming channel regions. Also, inside each stripe 11 two N+ source stripes 15 are provided; the N+ source stripes 15 substantially extend for the whole length of the stripe 11 (see Fig. 4).

As also shown in Figs. 2 and 5, a second plurality of P type stripes 14 (which in the shown embodiment are heavily doped P+ stripes) also departs horizontally from the P type ring 8. The stripes 14 of the second plurality are intercalated with the stripes 11 of the first plurality, i.e. between two stripes 11 there is always provided a stripe 14.

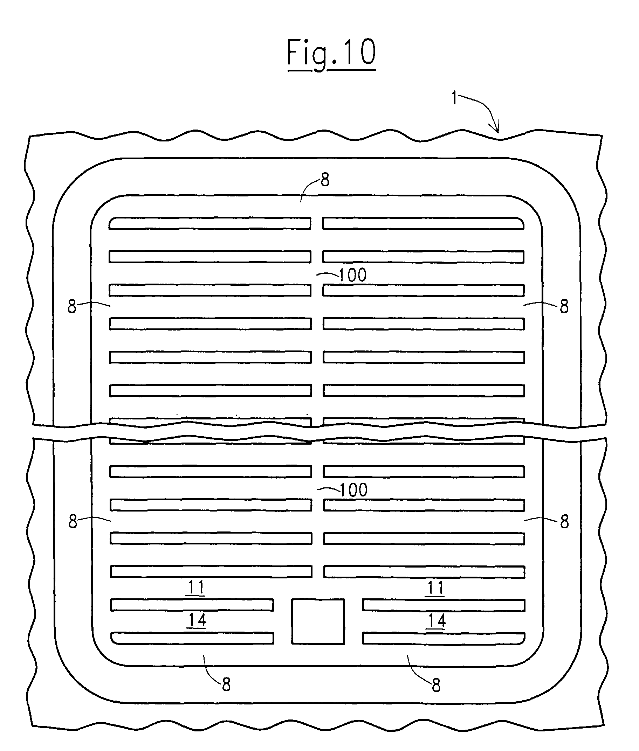

As shematically shown in Figure 10, a further P type stripe 100 extends orthogonally to the stripes 11 and the stripes 14 substantially in the middle portion of the chip, under the source plate 5; the P type stripe 100 is merged at its two ends with the P type ring 8, and the P type stripes 11 and 14 are also merged with the P type stripe 100 at their ends not merged with the P type ring 8. Thus, the P type ring 8, the P type stripes 11 and 14 and the P type stripe 100 are all merged together. Inside the P type body stripes 11 the N+ source stripes 15 extend substantially from the P type ring 8 to the P type stripe 100.

As shown in Figs. 2 and 6, N+ stripes 24 extend horizontally between the stripes 11 and 14. The stripes 24 are completely isolated one from the other, being surrounded at each side by P type regions.

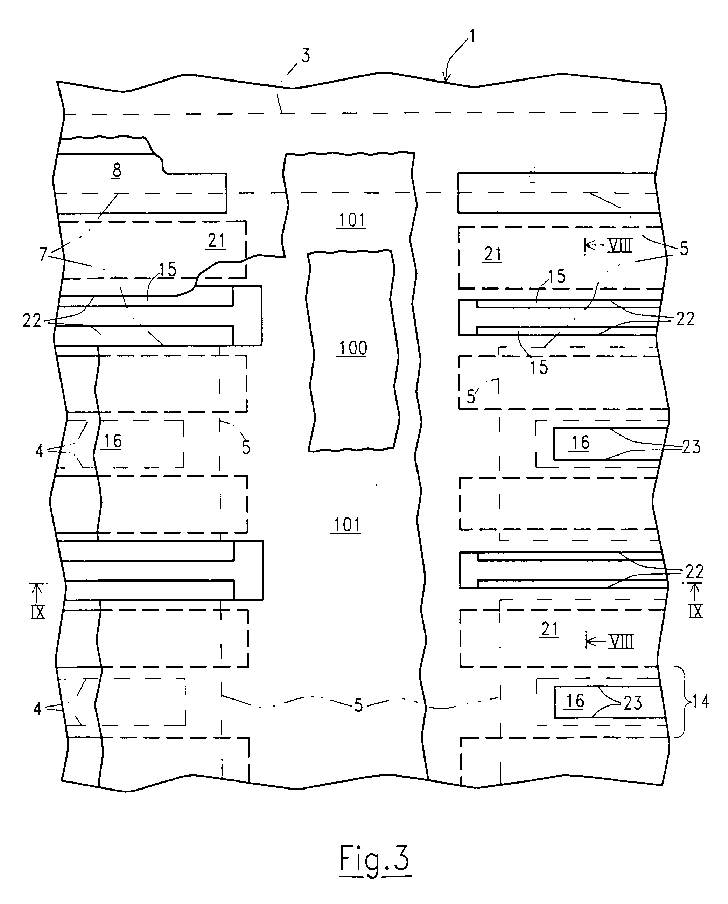

As shown in Fig. 2, stripes 16 of a conductive insulated gate layer extend horizontally over the P type stripes 14. The insulated gate stripes 16 extend from an insulated gate ring 104 running along the periphery of the chip over the P type rings 8 and 50. Each stripe 16 partially extends over the lightly doped portions 13 of two adjacent stripes 11. A stripe 101 of conductive insulated gate layer to which the stripes 16 of conductive insulated gate layer are connected extends vertically from the conductive insulated gate ring 104 over the P type stripe 100 (Figs. 3 and 9).

As shown in Figs. 7 and 8, over the P type stripes 14 the insulated gate stripes 16 comprise a polysilicon gate layer 18 insulated from the underlying silicon regions by an oxide layer 17. The oxide layer 17 comprises thin gate oxide portions 19 which extend over the lightly doped portions 13 of the stripes 11, and thicker portions 20 directly over the P type stripes 14. The use of a thicker oxide layer over the P type stripes 14 reduces the parasitic capacitance between the polysilicon gate layer 18 and the P type stripes 14, i.e. the gate-source (input) parasitic capacitance, thus improving the dynamic performances of the device. Also, it is advantageous from the point of view of the manufacturing yield, since it is known that heavily doped semiconductor regions such as the P type stripes 14 getter metal contaminants, and when a thin oxide layer is formed over such heavily doped regions these contaminants migrate in the oxide layer inducing defects.

As shown in Fig. 9, over the P type stripe 100 the polysilicon layer 18 is insulated from the underlying P type stripe 100 by a thick oxide layer 102.

A dielectric layer 21 is placed over the insulated gate stripes 16 and 101; elongated windows 22 and 23 are provided in the dielectric layer 21 respectively over the center of the stripes 11 and over the center of the stripes 14. Each source metal finger 7, placed over the dielectric layer 21, contacts the N+ source stripes 15 and the P+ portion 12 of a respective stripe 11; each gate finger 4, also placed over the dielectric layer 21, contacts a respective underlying stripe 16 of insulated gate layer. The gate fingers 4 can be made of metal, exactly as the source fingers 7, or they can be made of a silicide.

The P- ring 50 which surrounds the P type ring 8 is covered by a thick field oxide layer 51; the polysilicon layer 18 extends over the field oxide layer 26, where it is contacted by the gate ring 3.

As shown in Fig. 3, which is an enlarged view of upper-central portion of the chip of Figure 1, the windows 22 in the dielectric layer 21 have all substantially the same length and extend horizontally from the periphery of the chip to the P type stripe 100. At the center of the chip 1, where the source metal plate 5 is wider, the P+ portion 12 and the N+ source stripes 15 of each stripe 11 can be contacted by the source metal plate 5. The windows 23 are interrupted near the source plate 5, to prevent the source plate 5 to come into contact with the insulated gate layer 16 (Fig. 8); the length of the windows 23 becomes shorter going from the upper and lower sides of the chip 1 towards its center, where the source metal plate 5 is wider.

The whole chip is covered by a passivating layer 26, wherein windows are opened over the gate metal pad 2 and the pad area 6 of the source metal plate 5.

Thanks to the presence of the stripe 101 of insulated gate layer under the source metal plate 5, the gate resistance of the MOS power device is reduced. If the stripe 101 of insulated gate layer were absent, the portions of the body stripes 11 near the center of the chip, especially those under the source metal plate 5 where the insulated gate stripes 16 are not contacted by the gate metal fingers 4, would experience a higher gate resistance than the portions of the body stripes 11 near the periphery of the chip; in other words, the portions of the body stripes 11 under the source metal plate 5 would experience a higher input impedance than the portions of the body stripes 11 near the periphery of the chip. The presence of the central stripe 101 of insulated gate layer greatly reduces this problem, because the portions of the body stripes 11 under the source metal plate 5 can be easily reached by the gate signal.

The presence of the P type stripes 14 and 100 under the insulated gate layer 16 between adjacent body stripes 11 and under the insulated gate stripe 101 allows an improvement in the dynamic performances of the power device: in fact, being the P type stripes 14 and 100 at the source potential (because they are merged with the P type ring 8), the parasitic capacitance associated to the insulated gate layer 16 and 101 is an input capacitance, i.e. a capacitance between gate and source, while if the stripes were absent the parasitic capacitance associated to the insulated gate layer would be a capacitance between the polysilicon gate 18 and the N- layer 9, i.e. a gate-drain capacitance. Due to the Miller effect, a gate-drain capacitance affects more negatively the dynamic performances than an input capacitance.

The P type stripes 14 between adjacent body stripes 11 allow to flatten the electric field lines in the regions of the N- layer 9 between the stripes 11 when the device is strongly reverse-biased (high reverse voltage applied between source and drain). Crowding of the electric field lines is thus avoided, so that early breakdowns at the edges of the doped semiconductor stripes are prevented; this leads to an increase in the breakdown voltage. Experimental tests have proven that breakdown voltages of up to 40 V are attainable.

The presence of the N+ stripes 24 between the P type stripes 11 and 14 allows a reduction in the "on resistance" R_{DSon} of the power device.

A manufacturing process for a MOS-technology power device according to the present invention starts with a heavily doped semiconductor substrate 10. A lightly doped layer 9 is epitaxially grown over the substrate 10; the lightly doped layer 9 is of the N type for an N-channel device, and of the P type for a P-channel device.

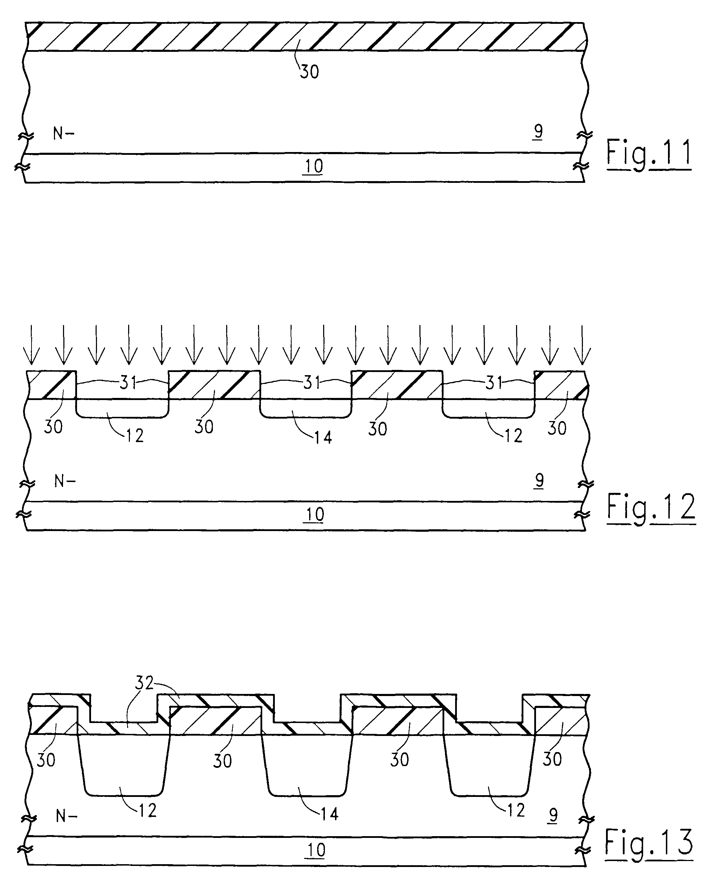

A thick field oxide layer 30 is formed over the N- layer 9 (Fig. 11). The field oxide layer 30 is then selectively removed to open therein windows 31 for the implantation of a P type dopant, to form the P type ring 8, the heavily doped P+ portions 12 of the body stripes 11, the P type stripes 14 and the P type stripe 100. The implant dose ranges between 10¹⁵-10¹⁶ atoms/cm² (Fig. 12). After this implantation, the field oxide layer 30 is again selectively removed, and a P type dopant is implanted in a dose of about 10¹² atoms/cm² to form the P- ring 50.

In another embodiment of the manufacturing process, the P type ring 8, the P type stripes 14 and the P type stripe 100 are formed by means of the same implantation used to form the P- ring 50. In this embodiment, the P type ring 8, the P type stripes 14 and the P type 100 are lightly doped P- regions, instead of heavily doped P+ type regions.

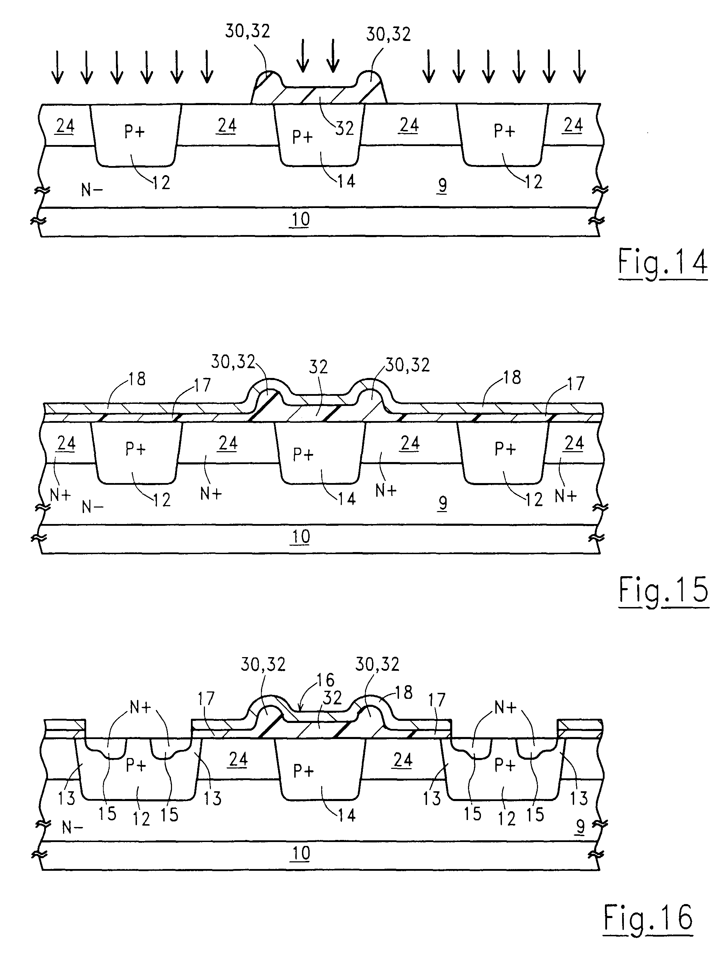

A thermal diffusion process is then performed submitting the chip to a temperature of about 1100-1200 °C for two-three hours, to make the implanted dopant diffuse. Successively, the chip is submitted to a temperature of about 1000 °C for five-six hours: an oxide layer 32 about 13000 Angstroms thick grows over the whole surface of the chip 1 (Fig. 13).

The oxide layers 32 and 30 are then completely removed except that near the edges of the chip (over the P- ring 50, see Figs. 4-6) and over the P type stripes 14 and 100: in this way, over the P type stripes 14 and over the P type stripe 100 a 13000 Angstroms thick oxide layer is left.

An N type dopant is implanted to form the N+ stripes 24; the implantation dose, of the order of 10¹² atoms/cm², is sufficiently low not to reverse the conductivity type of the already formed regions 12 and 14. After the implantation, an annealing treatment is performed (Fig. 14).

A thin gate oxide layer 17 is then formed over the surface of the chip; the oxide layer 17 has a typical thickness of about 1000 Angstroms.

A polysilicon layer 18 is deposited over the gate oxide layer 17 (Fig. 15).

The polysilicon layer 18 and the oxide layer 17 are then selectively removed over the stripes 12 to define the insulated gate stripes 16 and the insulated gate stripe 101 over the P type stripe 100.

A P type dopant is then implanted in a dose of about 10¹³ atoms/cm² and is then made to diffuse by means of thermal process at a temperature of about 1100 °C for six-seven hours to form the lightly doped portions 13 of the stripes 11 at the sides of the P+ portions 12 (Fig. 16).

An N type dopant is then selectively implanted in the stripes 11 to form the N+ source stripes 15; the N type dopant dose is of the order of 10¹⁵ atoms/cm². A short thermal diffusion process allows the diffusion of the N type dopant to form the source stripes 15.

A dielectric layer 21 is then deposited over the whole chip, and it is then selectively removed to open the contact windows 22 and 23.

A metal layer is deposited over the dielectric layer 21, and it is selectively removed to define the gate pad 2, the gate ring 3, the gate fingers 4, the source plate 5 and the source fingers 7.

It will be appreciated by those skilled in the art that the present invention not only applies to discrete power devices, as those previously described, but also to MOS-technology power devices integrated in Vertical Intelligent Power ("VIP") integrated circuits and BCD integrated circuits.

## Claims

1. MOS-technology power device integrated structure comprising a plurality of substantially parallel first elongated doped semiconductor stripes (11) of a second conductivity type formed in a semiconductor layer (9) of a second conductivity type, each of said elongated stripes (11) including a source region (15) of the first conductivity type, an annular doped semiconductor region (8) of the first conductivity type formed in the semiconductor layer (9) and surrounding and merged with said elongated stripes (11), a plurality of first conductive insulated gate stripes (16) each one extending over the semiconductor layer (9) between two respective adjacent elongated stripes (11), said first conductive insulated gate stripes (16) extending from a conductive insulated gate ring (104) surrounding and merged with said plurality of first conductive insulated gate stripes (16), a plurality of conductive gate fingers (4) each one extending over and electrically connected to a respective first conductive insulated gate stripe (16), and a plurality of source metal fingers (7), each one extending from a common source bonding pad (5) over a respective elongated stripe (11) and contacting said elongated stripe (11) and the respective source region (15), so that the source metal fingers (7) and the conductive gate fingers (4) are interdigitated, at least one second conductive insulated gate stripe (101) extending orthogonally to the first conductive insulated gate stripes (16) between two opposite sides of said conductive insulated gate ring (104) under said common source bonding pad (5), said second conductive insulated gate stripe (101) being electrically insulated from said source bonding pad (5), and being merged with said first conductive insulated gate stripes (16) at one end thereof and with said conductive insulated gate ring (104).

2. MOS-technology power device according to claim 1, characterized in that said at least one second insulated gate stripe (101) is insulatively placed over a respective second elongated doped semiconductor stripe (100) of the first conductivity type extending orthogonally to said first elongated doped semiconductor stripes (11) and merged at its ends with said annular doped semiconductor region (8).

3. MOS-technology power device integrated structure according to claim 2, characterized in that said conductive gate fingers (4) are connected to a conductive gate ring (3) surrounding the conductive gate fingers (4) and contacting the insulated gate ring (104), said conductive gate ring (3) being in turn connected to a gate pad (2).

4. MOS-technology power device integrated structure according to claim 3, characterized in that it comprises a plurality of third elongated doped semiconductor stripes (14) of the first conductivity type, merged at their ends with said annular doped semiconductor region (8) and with said second elongated doped semiconductor stripe (100), each third elongated doped semiconductor stripe (14) being located under a respective first insulated gate stripe (16), so that the first elongated doped semiconductor stripes (11) are intercalated by the second elongated doped semiconductor stripes (14).

5. MOS-technology power device integrated structure according to claim 4, characterized in that it comprises heavily doped semiconductor stripes (24) of the second conductivity type between the first and second elongated doped semiconductor stripes (11,14).

6. MOS-technology power device according to claim 5, characterized in that said at least one second insulated gate stripe (101) is insulated from the respective underlying second elongated doped semiconductor stripe (100) by means of an oxide layer (102).

7. MOS-technology power device integrated structure according to claim 6, characterized in that the first insulated gate stripes (16) are insulated from the underlyng semiconductor layer (9) by means of an oxide layer (17).

8. MOS-technology power device integrated structure according to claim 7, characterized in that said oxide layer (17) comprises thick field oxide areas (20) over the semiconductor layer (9) between the elongated stripes (11) of the first plurality, and thin gate oxide areas (19) partially extending over the first elongated stripes (11).

9. MOS-technology power device according to claim 8, characterized in that said oxide layer (102) insulating the at least one second insulated gate stripe (101) from the respective underlying doped semiconductor stripe (100) is a field oxide.

10. MOS-technology power device integrated structure according to anyone of the preceding claims, characterized in that said source region (15) comprises two laterally displaced elongated source regions (15).

11. MOS-technology power device integrated structure according to anyone of the preceding claims, characterized in that each first elongated doped semiconductor stripe (11) comprises a heavily doped elongated central portion (12) and two lateral lightly doped elongated lateral portions (13).

12. MOS-technology power device integrated structure according to anyone of the preceding claims, characterized in that said third elongated doped semiconductor stripes (14), said second elongated doped semiconductor stripe (100) and said annular doped semiconductor region (8) are heavily doped.

13. MOS-technology power device according to anyone of the claims 1 to 11, characterized in that said third elongated doped semiconductor stripes (14), said second elongated doped semiconductor stripe (100) and said annular doped semiconductor region (8) are lightly doped.

14. MOS-technology power device integrated structure according to anyone of the preceding claims, characterized in that said semiconductor layer (9) is lightly doped.

15. MOS-technology power device integrated structure according to anyone of the preceding claims, characterized in that said semiconductor layer (9) lies over a heavily doped semiconductor substrate (10).

16. MOS-technology power device integrated structure according to claim 15, characterized in that said semiconductor substrate (10) is of the second conductivity type.

17. MOS-technology power device integrated structure according to claim 15, characterized in that said semiconductor substrate (10) is of the first conductivity type.

18. MOS-technology power device integrated structure according to anyone of the preceding claims, characterized in that said first and second conductivity types are the P and N types, respectively.

19. MOS-technology power device integrated structure according to anyone of claims 1-17, characterized in that said first and second conductivity types are the N and P types, respectively.

20. Process for manufacturing a MOS-technology power device integrated structure, comprising the steps of forming a plurality of substantially parallel first elongated doped semiconductor stripes (11) of a first conductivity type and an annular doped semiconductor region (8) of the first conductivity type in a lightly doped semiconductor layer (9) of a second conductivity type, the annular doped semiconductor region (8) surrounding and being merged with the first elongated doped semiconductor stripes (11), forming source regions (15) of the second conductivity type in said elongated stripes (11), forming over the semiconductor layer (9) a conductive insulated gate ring (104), forming a plurality of first conductive insulated gate stripes (16) extending between and partially overlapping said first elongated doped semiconductor stripes (11) and surrounded by said insulated gate ring (104), forming at least one second insulated gate stripe (101) extending orthogonally to said first insulated gate stripes (16) between two opposite sides of said insulated gate ring (104) and merged with said insulated gate ring (104), said first insulated gate stripes (16) being merged at their ends with said insulated gate ring (104) and with said second insulated gate stripe (101), forming conductive gate fingers (4) each one extending over and contacting a respective first insulated gate stripe (16), forming a source metal plate (5) extending over and electrically insulated from said second insulated gate stripe (101), and forming source metal fingers (7) extending from the source metal plate, each source metal finger (7) extending over and contacting a respective first elongated doped semiconductor stripe (11) and the source region (15) formed therein.

21. Process according to claim 20, characterized by further providing for forming, under said at least one second insulated gate stripe (101) a respective second elongated doped semiconductor stripe (100) of the first conductivity type merged at its ends with said annular doped semiconductor region (8).

22. Process according to claim 21, characterized by further providing for forming a plurality of third elongated doped semiconductor stripes (14), surrounded by and merged with said annular region (8), each one intercalated with the first elongated doped semiconductor stripes (11).

23. Process according to claim 22, characterized by forming heavily doped semiconductor stripes (24) of the second conductivity type between the first and second elongated doped semiconductor stripes (11,14).

24. Process according to claim 23, characterized by the following steps:
a) selectively implanting and diffusing a dopant of the first conductivity type into the lightly doped semiconductor layer (9) to form said first and third elongated doped semiconductor stripes (11,14), said annular doped semiconductor region (8) and said second elongated doped semiconductor stripe (100);
b) implanting a dopant of the second conductivity type to form said heavily doped stripes (24) of the second conductivity type, said second dopant being implanted in a dose suitable not to invert the conductivity type of the first and third elongated doped semiconductor stripes (11,14), of the annular region (8) and of the second elongated doped semiconductor stripe (100);
c) forming a thin gate oxide layer (17);
d) forming a polysilicon layer (18) over the gate oxide layer (17);
e) selectively removing the polysilicon layer (18) and the gate oxide layer (17) to define said insulated gate ring (104), said first insulated gate stripes (16) and said at least one second insulated gate stripe (101);
f) implanting a low dose of a dopant of the first conductivity type to form lightly doped elongated channel portions (13) at the sides of the first elongated doped semiconductor stripes (11);
g) selectively implanting a heavy dose of a dopant of the second conductivity type to form said source regions (15);
h) forming a dielectric layer (21);
i) selectively removing the dielectric layer (21) to open elongated contact windows (22,23) respectively over the first elongated doped semiconductor stripes (11) and over the first insulated gate stripes (16);
l) forming a metal layer over the dielectric layer (21);
m) selectively removing the metal layer to form the source metal plate (5), said source metal fingers (7) and said conductive gate fingers (4).

## Patentansprüche

1. MOS-Technologie-Leistungsvorrichtung mit integrierter Struktur, die folgendes aufweist: eine Vielzahl von im wesentlichen parallelen ersten länglichen dotierten Halbleiterstreifen (11) eines zweiten Leitfähigkeitstyps, die in einer Halbleiterschicht (9) eines zweiten Leitfähigkeitstyps ausgebildet sind, wobei jeder der länglichen Streifen (11) einen Source-Bereich (15) des ersten Leitfähigkeitstyps, einen ringförmigen dotierten Halbleiterbereich (8) des ersten Leitfähigkeitstyps, der in der Halbleiterschicht (9) ausgebildet ist und die länglichen Streifen (11) umgibt und mit ihnen vereinigt ist, eine Vielzahl von ersten leitenden isolierten Gate-Streifen (16), von welchen sich jeder über der Halbleiterschicht (9) zwischen zwei jeweils benachbarten länglichen Streifen (11) erstreckt, wobei sich die ersten leitenden isolierten Gate-Streifen (16) von einem leitenden isolierten Gate-Ring (104) erstrecken, der die Vielzahl von ersten leitenden isolierten Gate-Streifen (16) umgibt und mit ihnen vereinigt ist, eine Vielzahl von leitenden Gate-Fingern (4), von welchen sich jeder über einem jeweiligen ersten leitenden isolierten Gate-Streifen (16) erstreckt und mit ihm elektrisch verbunden ist, und eine Vielzahl von Source-Metallfingern (7), von welchen sich jeder von einem gemeinsamen Source-Bondierungsanschlußflecken (5) über einem jeweiligen länglichen Streifen (11) erstreckt und den länglichen Streifen (11) und den jeweiligen Source-Bereich (15) kontaktiert, so daß die Source-Metallfinger (7) und die leitenden Gate-Finger (4) ineinandergreifen, wobei sich wenigstens ein zweiter leitender isolierter Gate-Streifen (101) orthogonal zu den ersten leitenden isolierten Gate-Streifen (16) zwischen zwei gegenüberliegenden Seiten des leitenden isolierten Gate-Rings (104) unter dem gemeinsamen Source-Bondierungsanschlußflecken (5) erstreckt, wobei der zweite leitende isolierte Gate-Streifen (101) vom Source-Bondierungsanschlußflecken (5) elektrisch isoliert ist und mit den ersten leitenden isolierten Gate-Streifen (16) an ihrem einen Ende und mit dem leitenden isolierten Gate-Ring (104) vereinigt ist.

2. MOS-Technologie-Leistungsvorrichtung nach Anspruch 1, dadurch gekennzeichnet, daß der wenigstens eine zweite leitende isolierte Gate-Streifen (101) über einem jeweiligen zweiten länglichen dotierten Halbleiterstreifen (100) des ersten Leitfähigkeitstyps isoliert angeordnet ist, der sich orthogonal zu den ersten länglichen dotierten Halbleiterstreifen (11) erstreckt und an seinen Enden mit dem ringförmigen dotierten Halbleiterbereich (8) vereinigt ist.

3. MOS-Technologie-Leistungsvorrichtung mit integrierter Struktur nach Anspruch 2, dadurch gekennzeichnet, daß die leitenden Gate-Finger (4) mit einem leitenden Gate-Ring (3) verbunden sind, der die leitenden Gate-Finger (4) umgibt und den isolierten Gate-Ring (104) kontaktiert, wobei der leitende Gate-Ring (3) wiederum mit einem Gate-Anschlußflecken (2) verbunden ist.

4. MOS-Technologie-Leistungsvorrichtung mit integrierter Struktur nach Anspruch 3, dadurch gekennzeichnet, daß sie eine Vielzahl von dritten länglichen dotierten Halbleiterstreifen (14) des ersten Leitfähigkeitstyps aufweist, die an ihren Enden mit dem ringförmigen dotierten Halbleiterbereich (8) und mit dem zweiten länglichen dotierten Halbleiterstreifen (100) vereinigt sind, wobei jeder dritte längliche dotierte Halbleiterstreifen (14) unter einem jeweiligen ersten isolierten Gate-Streifen (16) angeordnet ist, so daß die ersten länglichen dotierten Halbleiterstreifen (11) durch die zweiten länglichen dotierten Halbleiterstreifen (14) eingeschlossen sind.

5. MOS-Technologie-Leistungsvorrichtung mit integrierter Struktur nach Anspruch 4, dadurch gekennzeichnet, daß sie stark dotierte Halbleiterstreifen (24) des zweiten Leitfähigkeitstyps zwischen den ersten und zweiten länglichen dotierten Halbleiterstreifen (11, 14) aufweist.

6. MOS-Technologie-Leistungsvorrichtung nach Anspruch 5, dadurch gekennzeichnet, daß der wenigstens eine zweite isolierte Gate-Streifen (101) vom jeweils darunterliegenden zweiten länglichen dotierten Halbleiterstreifen (100) mittels einer Oxidschicht (102) isoliert ist.

7. MOS-Technologie-Leistungsvorrichtung mit integrierter Struktur nach Anspruch 6, dadurch gekennzeichnet, daß die ersten isolierten Gate-Streifen (16) von der darunterliegenden Halbleiterschicht (9) mittels einer Oxidschicht (17) isoliert sind.

8. MOS-Technologie-Leistungsvorrichtung mit integrierter Struktur nach Anspruch 7, dadurch gekennzeichnet, daß die Oxidschicht (17) dicke Feldoxidbereiche (20) über der Halbleiterschicht (9) zwischen den länglichen Streifen (11) der ersten Vielzahl aufweist, und dünne Gate-Oxidbereiche (19), die sich teilweise über den ersten länglichen Streifen (11) erstrecken.

9. MOS-Technologie-Leistungsvorrichtung nach Anspruch 8, dadurch gekennzeichnet, daß die Oxidschicht (102), die den wenigstens einen zweiten isolierten Gate-Streifen (101) vom jeweils darunterliegenden dotierten Halbleiterstreifen (100) isoliert, ein Feldoxid ist.

10. MOS-Technologie-Leistungsvorrichtung mit integrierter Struktur nach einem der vorangehenden Ansprüche, dadurch gekennzeichnet, daß der Source-Bereich (15) zwei lateral versetzte längliche Source-Bereiche (15) aufweist.

11. MOS-Technologie-Leistungsvorrichtung mit integrierter Struktur nach einem der vorangehenden Ansprüche, dadurch gekennzeichnet, daß jeder erste längliche dotierte Halbleiterstreifen (11) einen stark dotierten länglichen zentralen Teil (12) und zwei laterale leicht dotierte längliche laterale Teile (13) aufweist.

12. MOS-Technologie-Leistungsvorrichtung mit integrierter Struktur nach einem der vorangehenden Ansprüche, dadurch gekennzeichnet, daß die dritten länglichen dotierten Halbleiterstreifen (14), der zweite längliche dotierte Halbleiterstreifen (100) und der ringförmige dotierte Halbleiterbereich (8) stark dotiert sind.

13. MOS-Technologie-Leistungsvorrichtung nach einem der Ansprüche 1 bis 11, dadurch gekennzeichnet, daß die dritten länglichen dotierten Halbleiterstreifen (14), der zweite längliche dotierte Halbleiterstreifen (100) und der ringförmige dotierte Halbleiterbereich (8) leicht dotiert sind.

14. MOS-Technologie-Leistungsvorrichtung mit integrierter Struktur nach einem der vorangehenden Ansprüche, dadurch gekennzeichnet, daß die Halbleiterschicht (9) leicht dotiert ist.

15. MOS-Technologie-Leistungsvorrichtung mit integrierter Struktur nach einem der vorangehenden Ansprüche, dadurch gekennzeichnet, daß die Halbleiterschicht (9) über einem stark dotierten Halbleitersubstrat (10) liegt.

16. MOS-Technologie-Leistungsvorrichtung mit integrierter Struktur nach Anspruch 15, dadurch gekennzeichnet, daß das Halbleitersubstrat (10) vom zweiten Leitfähigkeitstyp ist.

17. MOS-Technologie-Leistungsvorrichtung mit integrierter Struktur nach Anspruch 15, dadurch gekennzeichnet, daß das Halbleitersubstrat (10) vom ersten Leitfähigkeitstyp ist.

18. MOS-Technologie-Leistungsvorrichtung mit integrierter Struktur nach einem der vorangehenden Ansprüche, dadurch gekennzeichnet, daß der erste und der zweite Leitfähigkeitstyp jeweils der P- und der N-Typ sind.

19. MOS-Technologie-Leistungsvorrichtung mit integrierter Struktur nach einem der Ansprüche 1 - 17, dadurch gekennzeichnet, daß der erste und der zweite Leitfähigkeitstyp jeweils der N- und der P-Typ sind.

20. Verfahren zum Herstellen einer MOS-Technologie-Leistungsvorrichtung mit integrierter Struktur, das folgende Schritte aufweist: Ausbilden einer Vielzahl von im wesentlichen parallelen ersten länglichen dotierten Halbleiterstreifen (11) eines ersten Leitfähigkeitstyps und eines ringförmigen dotierten Halbleiterbereichs (8) des ersten Leitfähigkeitstyps in einer leicht dotierten Halbleiterschicht (9) eines zweiten Leitfähigkeitstyps, wobei der ringförmige dotierte Halbleiterbereich (8) die ersten länglichen dotierten Halbleiterstreifen (11) umgibt und mit ihnen vereinigt ist, Ausbilden von Source-Bereichen (15) des zweiten Leitfähigkeitstyps in den länglichen Streifen (11), Ausbilden eines leitenden isolierten Gate-Rings (104) über der Halbleiterschicht (9), Ausbilden einer Vielzahl von ersten leitenden isolierten Gate-Streifen (16), die sich zwischen den ersten länglichen dotierten Halbleiterstreifen (11) erstrecken und diese teilweise überlagern und durch den isolierten Gate-Ring (104) umgeben sind, Ausbilden von wenigstens einem zweiten isolierten Gate-Streifen (101), der sich orthogonal zu den ersten isolierten Gate-Streifen (16) zwischen zwei gegenüberliegenden Seiten des isolierten Gate-Rings (104) erstreckt und mit dem isolierten Gate-Ring (104) vereinigt ist, wobei die ersten isolierten Gate-Streifen (16) an ihren Enden mit dem isolierten Gate-Ring (104) und mit dem zweiten isolierten Gate-Streifen (101) vereinigt sind, Ausbilden von leitenden Gate-Fingern (4), von welchen sich jeder über einem jeweiligen ersten isolierten Gate-Streifen (16) erstreckt und diesen kontaktiert, Ausbilden einer Source-Metallplatte (5), die sich über dem zweiten isolierten Gate-Streifen (101) erstreckt und von diesem elektrisch isoliert ist, und Ausbilden von Source-Metallfingern (7), die sich von der Source-Metallplatte erstrecken, wobei sich jeder Source-Metallfinger (7) über einem jeweiligen ersten länglichen dotierten Halbleiterstreifen (11) und dem darin ausgebildeten Source-Bereich (15) erstreckt und diese kontaktiert.

21. Verfahren nach Anspruch 20, dadurch gekennzeichnet, daß es weiterhin vorgesehen ist zum Ausbilden, unter dem wenigstens einen zweiten isolierten Gate-Streifen (101), eines jeweiligen zweiten länglichen dotierten Halbleiterstreifens (100) des ersten Leitfähigkeitstyps, der an seinen Enden mit dem ringförmigen dotierten Halbleiterbereich (8) vereinigt ist.

22. Verfahren nach Anspruch 21, dadurch gekennzeichnet, daß es weiterhin vorgesehen ist zum Ausbilden einer Vielzahl von dritten länglichen dotierten Halbleiterstreifen (14), die durch den ringförmigen Bereich (8) umgeben sind und mit diesem vereinigt sind, wobei jeder von den ersten länglichen dotierten Halbleiterstreifen (11) eingeschlossen ist.

23. Verfahren nach Anspruch 22, gekennzeichnet durch Ausbilden von stark dotierten Halbleiterstreifen (24) des zweiten Leitfähigkeitstyps zwischen den ersten und zweiten länglichen dotierten Halbleiterstreifen (11, 14).

24. Verfahren nach Anspruch 23, gekennzeichnet durch folgende Schritte:
a) selektives Implantieren und Diffundieren eines Dotierungsmittels des ersten Leitfähigkeitstyps in die leicht dotierte Halbleiterschicht (9), um die ersten und dritten länglichen dotierten Halbleiterstreifen (11, 14), den ringförmigen dotierten Halbleiterbereich (8) und den zweiten länglichen dotierten Halbleiterstreifen (100) auszubilden;
b) Implantieren eines Dotierungsmittels des zweiten Leitfähigkeitstyps, um die stark dotierten Streifen (24) des zweiten Leitfähigkeitstyps auszubilden, wobei das zweite Dotierungsmittel in einer Dosis implantiert wird, die geeignet ist, den Leitfähigkeitstyp der ersten und dritten länglichen dotierten Halbleiterstreifen (11, 14), des ringförmigen Bereichs (8) und des zweiten länglichen dotierten Halbleiterstreifens (100) nicht zu invertieren;
c) Ausbilden einer dünnen Gate-Oxidschicht (17);
d) Ausbilden einer Polysiliziumschicht (18) über der Gate-Oxidschicht (17);
e) selektives Entfernen der Polysiliziumschicht (18) und der Gate-Oxidschicht (17), um den isolierten Gate-Ring (104), die ersten isolierten Gate-Streifen (16) und den wenigstens einen zweiten isolierten Gate-Streifen (101) zu definieren;
f) Implantieren einer niedrigen Dosis eines Dotierungsmittels des ersten Leitfähigkeitstyps, um leicht dotierte längliche Kanalteile (13) an den Seiten der ersten länglichen dotierten Halbleiterstreifen (11) auszubilden;
g) selektives Implantieren einer starken Dosis eines Dotierungsmittels des zweiten Leitfähigkeitstyps, um die Source-Bereiche (15) auszubilden;
h) Ausbilden einer dielektrischen Schicht (21);
i) selektives Entfernen der dielektrischen Schicht (21), um längliche Kontaktfenster (22, 23) jeweils über den ersten länglichen dotierten Halbleiterstreifen (11) und über den ersten isolierten Gate-Streifen (16) zu öffnen;
l) Ausbilden einer Metallschicht über der dielektrischen Schicht (21);
m) selektives Entfernen der Metallschicht, um die Source-Metallplatte (5), die Source-Metallfinger (7) und die leitenden Gate-Finger (4) auszubilden.

## Revendications

1. Structure intégrée de dispositif de puissance MOS, comprenant une pluralité de premières bandes semiconductrices allongées dopées sensiblement parallèles (11) d'un deuxième type de conductivité formées dans une couche semiconductrice (9) du deuxième type de conductivité, chacune desdites bandes allongées (11) comportant une région source (15) du premier type de conductivité, une région semiconductrice annulaire dopée (8) du premier type de conductivité formée dans la couche conductrice (9), entourant lesdites bandes allongées (11) et se fondant avec elles, une pluralité de premières bandes grille isolée conductrices (16) s'étendant chacune au-dessus de la couche semiconductrice (9) entre deux bandes allongées adjacentes (11) respectives, lesdites premières bandes grille isolée conductrices (16) s'étendant depuis une bague grille isolée conductrice (104) entourant ladite pluralité de premières bandes grille isolée conductrices (16) et se fondant avec elles, une pluralité de doigts grille conducteurs (4) s'étendant chacun au-dessus d'une première bande grille isolée conductrice (16) respective et étant électriquement connectée à celle-ci, et une pluralité de doigts métalliques source (7), chacun s'étendant depuis un plot de liaison source commun (5) sur une bande allongée respective (11) et venant en contact avec ladite bande allongée (11) et la région source respective (15), de façon que les doigts métalliques source (7) et les doigts grille conducteur (4) soient interdigités, au moins une deuxième bande grille isolée conductrice (101) s'étendant perpendiculairement aux premières bandes grille isolée conductrices (16) entre deux côtés opposés de ladite bague grille isolée conductrice (104) sous ledit plot de liaison source commun (5), ladite deuxième bande grille isolée conductrice (101) étant électriquement isolée vis-à-vis dudit plot de liaison source (5) et se fondant avec lesdites premières bandes grille isolée conductrices (16) au niveau d'une extrémité et avec ladite bague grille isolée conductrice (104).

2. Structure intégrée de dispositif de puissance MOS selon la revendication 1, caractérisée en ce que ladite au moins une deuxième bande grille isolée (101) est placée, de manière à en être isolée, sur une deuxième bande semiconductrice allongée dopée (100) respective du premier type de conductivité s'étendant perpendiculairement auxdites premières bandes semiconductrices allongées dopées (11) et se fondant, au niveau de son extrémité, avec ladite région semiconductrice annulaire dopée (8).

3. Structure intégrée de dispositif de puissance MOS selon la revendication 2, caractérisée en ce que lesdits doigts grille conducteurs (4) sont connectés à une bague grille conductrice (3) entourant lesdits doigts grille conducteurs (4) et étant en contact avec la bague grille isolée (104), ladite bague grille conductrice (3) étant elle-même connectée à un plot de grille (2).

4. Structure intégrée de dispositif de puissance MOS selon la revendication 3, caractérisée en ce qu'elle comprend une pluralité de troisièmes bandes semiconductrices allongées dopées (14) du premier type de conductivité, se fondant, au niveau de leurs extrémités, avec ladite région semiconductrice annulaire dopée (8) et avec ladite deuxième bande semiconductrice allongée dopée (100), chaque troisième bande semiconductrice allongée dopée (14) étant placée sous une première bande grille isolée (16) respective, de façon que les premières bandes semiconductrices allongées dopées (11) soient intercalées par les deuxièmes bandes semiconductrices allongées dopées (14).

5. Structure intégrée de dispositif de puissance MOS selon la revendication 4, caractérisée en ce qu'elle comprend des bandes semiconductrices fortement dopées (24) du deuxième type de conductivité entre les premières et deuxièmes bandes semiconductrices allongées dopées.

6. Structure intégrée de dispositif de puissance MOS selon la revendication 5, caractérisée en ce que ladite au moins une deuxième bande grille isolée (101) est isolée vis-à-vis de la deuxième bande semiconductrice allongée dopée sous-jacente (100) respective au moyen d'une couche d'oxyde (102).

7. Structure intégrée de dispositif de puissance MOS selon la revendication 6, caractérisée en ce que les premières bandes grille isolée (16) sont isolées vis-à-vis de la couche semiconductrice (9) sous-jacente au moyen d'une couche d'oxyde (17).

8. Structure intégrée de dispositif de puissance MOS selon la revendication 7, caractérisée en ce que ladite couche d'oxyde (17) comprend des aires d'oxyde de champ épais (20) disposées sur la couche semiconductrice (9) entre les bandes allongées (11) de la première pluralité, et des aires d'oxyde de grille épais (19) s'étendant partiellement sur les premières bandes allongées (11).

9. Structure intégrée de dispositif de puissance MOS selon la revendication 8, caractérisée en ce que ladite couche d'oxyde (102) isolant ladite au moins une deuxième bande grille isolée (101) vis-à-vis de la bande semiconductrice dopée sous-jacente (100) respective est un oxyde de champ.

10. Structure intégrée de dispositif de puissance MOS selon l'une quelconque des revendications précédentes, caractérisée en ce que ladite région source (15) comprend deux régions source allongées latéralement déplacées (15).

11. Structure intégrée de dispositif de puissance MOS selon l'une quelconque des revendications précédentes, caractérisée en ce que chaque première bande semiconductrice allongée dopée (11) comprend une partie centrale allongée fortement dopée (12) et deux parties latérales allongées légèrement dopées (13).

12. Structure intégrée de dispositif de puissance MOS selon l'une quelconque des revendications précédentes, caractérisée en ce que lesdites troisièmes bandes semiconductrices allongées dopées (14), ladite deuxième bande semiconductrice allongée dopée (100) et ladite région semiconductrice annulaire dopée (8) sont fortement dopées.

13. Structure intégrée de dispositif de puissance MOS selon l'une quelconque des revendications 1 à 11, caractérisée en ce que lesdites troisièmes bandes semiconductrices allongées dopées (14), ladite deuxième bande semiconductrice allongée dopée (100) et ladite région semiconductrice annulaire dopée (8) sont légèrement dopées.

14. Structure intégrée de dispositif de puissance MOS selon l'une quelconque des revendications précédentes, caractérisée en ce que ladite couche semiconductrice (9) est légèrement dopée.

15. Structure intégrée de dispositif de puissance MOS selon l'une quelconque des revendications précédentes, caractérisée en ce que ladite couche semiconductrice (9) s'étend sur un substrat semiconducteur fortement dopé (10).

16. Structure intégrée de dispositif de puissance MOS selon la revendication 15, caractérisée en ce que ledit substrat semiconducteur (10) est du deuxième type de conductivité.

17. Structure intégrée de dispositif de puissance MOS selon la revendication 15, caractérisée en ce que ledit substrat semiconducteur (10) est du premier type de conductivité.

18. Structure intégré de dispositif de puissance MOS selon l'une quelconque des revendications précédentes, caractérisée en ce que lesdits premier et deuxième types de conductivité sont respectivement le type P et le type N.

19. Structure intégré de dispositif de puissance MOS selon l'une quelconque des revendications 1 à 17, caractérisée en ce que lesdits premier et deuxième types de conductivité sont respectivement le type N et le type P.

20. Procédé de fabrication d'une structure intégrée de dispositif de puissance MOS, comprenant les opérations suivantes : former une pluralité de premières bandes semiconductrices allongées dopées sensiblement parallèles (11) d'un premier type de conductivité et une région semiconductrice annulaire dopée (8) du premier type de conductivité dans une couche semiconductrice légèrement dopée (9) du deuxième type de conductivité, la région semiconductrice annulaire dopée (8) entourant les premières bandes semiconductrices allongées dopées (11) et se fondant avec elles, former des régions source (15) du deuxième type de conductivité dans lesdites bandes allongées (11), former sur la couche conductrice (9) une bague grille isolée conductrice (104), former une pluralité de premières bandes grille isolée conductrices (16) s'étendant entre et chevauchant partiellement lesdites premières bandes semiconductrices allongées dopées (11) et entourées par ladite bague grille isolée (104), former au moins une deuxième bande grille isolée (101) s'étendant perpendiculairement auxdites premières bandes grille isolée (16) entre deux côtés opposés de ladite bague grille isolée (104) et se fondant avec ladite bague grille isolée (104), lesdites premières bandes grille isolée (16) se fondant, au niveau de leurs extrémités, avec ladite bague grille isolée (104) et avec ladite deuxième bande grille isolée (101), former des doigts grille conducteurs (4) s'étendant chacun au-dessus d'une première bande grille isolée (16) respective et étant en contact avec cette dernière, former une plaque métallique source (5) s'étendant au-dessus, tout en en étant électriquement isolée de ladite deuxième bande grille isolée (5) et formant des doigts métalliques source (7) qui s'étendent depuis ladite plaque métallique source, chaque doigt métallique source (7) s'étendant sur une première bande semiconductrice allongée dopée (11) respective et la région source (15) qui y est formée et étant en contact avec ces dernières.

21. Procédé selon la revendication 20, caractérisé par l'opération consistant à former, sous ladite au moins une deuxième bande grille isolée (101), une deuxième bande semiconductrice allongée dopée (100) respective du premier type de conductivité se fondant, au niveau de ses extrémités, avec ladite région semiconductrice annulaire dopée (8).

22. Procédé selon la revendication 21, caractérisé en ce qu'il comprend en outre l'opération consistant à former une pluralité de troisièmes bandes semiconductrices allongées dopées (14), entourées par ladite région annulaire (8) et se fondant avec elle, chacune étant intercalées avec les premières bandes semiconductrices allongées dopées (11).

23. Procédé selon la revendication 22, caractérisé en ce qu'il comprend l'opération consistant à former des bandes semiconductrices fortement dopées (24) du deuxième type de conductivité entre les premières et deuxièmes bandes semiconductrices allongées dopées (11, 14).

24. Procédé selon la revendication 23, caractérisé par les opérations suivantes :
a) sélectivement implanter et diffuser un agent dopant du premier type de conductivité dans la couche semiconductrice légèrement dopée (9) afin de former lesdites premières et troisièmes bandes semiconductrices allongées dopées (11, 14), ladite région semiconductrice annulaire dopée (8) et ladite deuxième bande semiconductrice allongée dopée (100);
b) implanter un agent dopant du deuxième type de conductivité afin de former lesdites bandes fortement dopées (24) du deuxième type de conductivité, ledit deuxième agent dopant étant implanté avec une dose convenant pour ne pas inverser le type de conductivité des premières et troisièmes bandes semiconductrices allongées dopées (11, 14), de la région annulaire (8) et de la deuxième bande semiconductrice allongée dopée (100);
c) former une mince couche d'oxyde de grille (17);
d) former une couche de silicium polycristallin (18) sur la couche d'oxyde de grille (17);
e) retirer sélectivement la couche de silicium polycristallin (18) et la couche d'oxyde de grille (17) afin de définir ladite bague grille isolée (104), lesdites premières bandes grille isolée (16) et ladite au moins une deuxième bande grille isolée (101);
f) implanter une faible dose d'un agent dopant du premier type de conductivité afin de former des parties de canal allongées légèrement dopées (13) au niveau des côtés des premières bandes semiconductrices allongées dopées (11);
g) implanter sélectivement une forte dose d'un agent dopant du deuxième type de conductivité afin de former lesdites régions source (15);
h) former une couche diélectrique (21);
i) retirer sélectivement la couche diélectrique (21) de façon à ouvrir des fenêtres de contact allongées (22, 23) respectivement sur les premières bandes semiconductrices allongées dopées (11) et sur les premières bandes grille isolée (16);
l) former une couche métallique sur la couche diélectrique (21);
m) sélectivement retirer la couche métallique afin de former la plaque métallique source (5), lesdits doigts métalliques source (7) et lesdits doigts grille conducteurs (4).
